# EUROPEAN PATENT SPECIFICATION

(11) **EP 3 361 333 B1**
(45) Date of publication and mention of the grant of the patent: **23.10.2019**
(21) Application number: 17202276.6
(22) Date of filing: 17.11.2017
(51) Int. Cl.: G05B 19/05, G05B 23/02, G11C 29/52, G06F 11/10

(54) **CONTROL DEVICE AND METHOD OF CONTROLLING THE SAME**
STEUERUNGSVORRICHTUNG UND VERFAHREN ZUR STEUERUNG DER STEUERUNGSVORRICHTUNG
DISPOSITIF DE COMMANDE ET SON PROCÉDÉ DE COMMANDE

(30) Priority: 08.02.2017 JP 2017021057
(43) Date of publication of application: 15.08.2018
(73) Proprietor: Omron Corporation, Kyoto-shi, Kyoto 600-8530 (JP)
(72) Inventor: ICHIMURA, Katsuhiko, KYOTO, 600-8530 (JP)
(74) Representative: 2K Patentanwälte Blasberg Kewitz & Reichel

(56) References cited:
- EP-A1- 1 848 001
- WO-A1-2014/115289
- US-B1- 8 010 871

## Description

### BACKGROUND OF THE INVENTION

### Field of the Invention

The disclosure relates to a control device including at least a programmable circuit unit and an arithmetic processing unit connected to the programmable circuit unit and capable of executing a user program in the arithmetic processing unit, and a control method therefor.

### Description of Related Art

Machines and facilities that are used in a large number of production sites are typically controlled by a control device such as a programmable logic controller (hereinafter also referred to as a PLC). Typically, the control program executed by such a control device is created by a user operating an information processing device called a support device and designing the control program. Such a program that is freely designed and created by the user is also called a user program.

The PLC includes a central processing unit (CPU), and a functional unit such as an input and output (I/O) unit which is responsible for inputting signals from external switches or sensors and outputting signals to external relays or actuators. The functional unit may be realized using a programmable circuit such as a field-programmable gate array (FPGA) in some cases.

However, while a user can independently build a circuit with the programmable circuit, there is a possibility of occurrence of a soft error in which information of a Config RAM (hereinafter also referred to as a CRAM) storing configuration data is changed due to radiation or the like. In particular, when a static random access memory (SRAM) is used for the CRAM, the possibility of the occurrence of the soft error is remarkable.

Therefore, JP 2014-052781 A discloses a configuration in which a surveillance control circuit is provided in order to detect a soft error in the FPGA. Specifically, the surveillance control circuit includes a checking means for checking presence of an error in stored data of a CRAM provided in the FPGA, and a recording means for recording error detection information and detection date and time information when an error is detected by the checking means, and can display that the error has occurred to the outside when the information is recorded on the recording means.

However, the surveillance control circuit disclosed in JP 2014-052781 A can only determine whether a soft error occurs in the CRAM storing the configuration data, and needs to stop the control device even when the generated soft error is at a position unrelated to a functional unit configured in the programmable circuit. Therefore, even when a soft error that does not affect a function of the control device occurs, the control device stops such that unnecessary stop occurs.

EP 1 848 001 A1 discloses a programmable logic device, controlled by configuration data stored in a CRAM. Unnecessary reconfigurations of programmable devices are reduced by ignoring soft errors in CRAM that do not significantly affect the operation of the programmable device. The device first uses error check bits to detect and locate soft errors that potentially affect the operation of the device. After that, it is determined whether the soft error is one that significantly affects device performance to an undesirable degree, or whether it is one that can be ignored. Determining that the position of the soft error corresponds to a first or second functional unit and switching to a degeneration operation depending on such a determination is not disclosed.

US 8 010 871 B1 discloses a similar method of recovering from a soft error within configuration data stored in a configured programmable logic device. The method includes repeatedly processing the configuration data stored within configuration memory of the device using an error-detection algorithm to generate a checksum. The generated checksum is compared with a previously generated checksum to detect if a soft error exists in the configuration data. If a soft error is detected, the programmable logic device initiates a reconfiguration of the configuration memory, The configuration memory is then reconfigured with the configuration data while preventing the programmable logic device from responding to the reconfiguration as though the reconfiguration was an initial configuration of the device.
WO 2014/115289 A1 discloses a programmable device performing a method similar to US 8 010 871 B1.

### SUMMARY OF THE INVENTION

It is an object of the present invention to provide a control device comprising at least a programmable circuit unit and an arithmetic processing unit that can more efficiently deal with the consequences of the occurrence of soft errors. It is a further object of the present invention to provide a corresponding method of controlling such a control device.
These problems are solved by a control device as claimed by claim 1, and by a method of controlling a control device as claimed by claim 8, Further advantageous embodiments are the subject-matter of the dependent claims.

### BRIEF DESCRIPTION OF THE DRAWINGS

FIG. 1 is a block diagram illustrating an example of a hardware configuration of a control device according to this embodiment.
FIG. 2 is a block diagram illustrating an example of soft error detection in an FPGA unit according to this embodiment.
FIG. 3 is a timing chart illustrating an example of read timing of error information in an error reading unit in this embodiment.
FIG 4 is a diagram illustrating an example of map information in this embodiment.
FIG 5 is a flowchart illustrating a process performed when an abnormality is detected in this embodiment.

### DESCRIPTION OF THE EMBODIMENTS

An object of one or some exemplary embodiments of the invention is to provide a control device capable of preventing unnecessary stop in the control device including at least a programmable circuit unit and an arithmetic processing unit connected to the programmable circuit unit, and capable of executing a user program in the arithmetic processing unit, and a method of controlling the control device.

According to one or some exemplary embodiments of the invention, the predetermined process is a process of stopping the programmable circuit unit. According to one or some exemplary embodiments of the invention, the predetermined process is a process of switching to a degeneration operation in which only the functional unit at the position of the soft error is stopped.

According to one or some exemplary embodiments of the invention, the functional unit includes a first functional unit including a redundant circuit and a second functional unit including a non-redundant circuit, and the arithmetic processing unit stops only a circuit at the position of the soft error and continuously operates the control device when the abnormality determination unit determines that the position of the soft error corresponds to the first functional unit, and executes a process of switching to a degeneration operation in which only the functional unit at the position of the soft error is stopped when the abnormality determination unit determines that the position of the soft error corresponds to the second functional unit.

According to one or some exemplary embodiments of the invention, the error detection unit is capable of dividing the storage unit into predetermined blocks and detecting a soft error for each block.

According to one or some exemplary embodiments of the invention, the abnormality determination unit executes the predetermined process in consideration of whether or not the position is a position of the soft error detected in the past.

According to one or some exemplary embodiments of the invention, the error detection unit performs error detection using a cyclic redundancy check (CRC) code.

According to one or some exemplary embodiments of the invention, the programmable circuit unit is a field-programmable gate array (FPGA) in which configuration data is stored in a static random access memory (SRAM) of the storage unit.

According to the control device of one or some exemplary embodiments of the invention, since the abnormality determination unit can determine whether the position of the soft error corresponds to a portion of the programmable circuit unit unused (an unused portion) or a portion of the programmable circuit unit used (a used portion) by the functional unit, it is possible to prevent unnecessary stop while realizing high reliability.

Hereinafter, embodiments will be described in detail with reference to the drawings. In the drawings, the same or corresponding units are denoted with the same reference numerals.

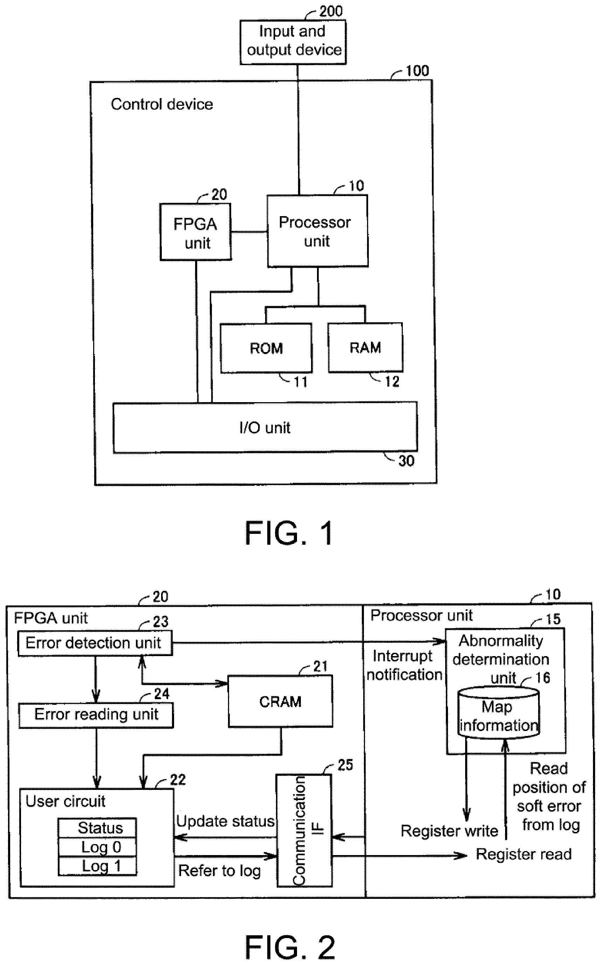

FIG. 1 is a block diagram illustrating an example of a hardware configuration of a control device according to this embodiment. The control device 100 of this embodiment is mounted, for example, using a programmable logic controller (PLC). The control device 100 applies a command value that is calculated by executing a previously stored program (a system program, a user program, or the like) to a control target (for example, a motor driver) connected via an input and output (I/O) unit 30, and acquires a state value from the control target. That is, the control device 100 can dynamically generate an appropriate command value and appropriately perform control according to a situation by feeding back the state value of the control target.

Further, as illustrated in FIG. 1, the control device 100 includes a processor unit 10, an FPGA unit 20, a ROM 11, a RAM 12, and the I/O unit 30. Each component in the control device 100 is connected by a bus.

The processor unit 10 mainly performs a process related to control or an operation of the control target by executing a program stored in the ROM 11 or the RAM 12. The FPGA unit (programmable circuit unit) 20 constitutes a functional unit and executes a specific process on digital values input from the processor unit 10. The ROM 11 stores a program for controlling the control device 100, data necessary for an operation of the program, and the like. The RAM 12 operates as a work area of the processor unit 10. The I/O unit 30 provides an interface with the control target. An input and output device 200 is a device that presents information to the user and receives an operation input from the user, such as a touch panel.

In order for the FPGA unit 20 to be configured as a functional unit that executes a specific process, a configuration for writing configuration data in a device may be required. Generally, the configuration is performed on the FPGA unit 20 immediately after power is turned on, and a functional unit capable of performing a desired circuit operation is obtained.

However, since there is a possibility of occurrence of the soft error in which information of the CRAM storing the configuration data is changed due to radiation or the like, the FPGA unit 20 performs error detection in order to detect the soft error of the CRAM. Hereinafter, soft error detection of the FPGA unit 20 will be described in detail. FIG. 2 is a block diagram illustrating an example of the soft error detection of the FPGA unit 20 in this embodiment.

The FPGA unit 20 performs configuration for writing the configuration data stored in the CRAM 21 to the device, such that a user circuit 22 constituting a functional unit is set. Here, the CRAM 21 is, for example, a static random access memory (SRAM).

The FPGA unit 20 includes an error detection unit 23 that detects the soft error of the CRAM 21. The error detection unit 23 detects the soft error using a cyclic redundancy check (CRC) code. Specifically, the error detection unit 23 adds the CRC code to each frame of the CRAM 21 and performs CRC check on a frame basis to perform detection of the soft error. The error detection unit 23 sequentially performs CRC check on a plurality of frames included in the FPGA unit 20 for determining whether or not a calculated CRC code and the added CRC code match, and performs CRC check again cyclically from the first frame when the CRC check of all the frames is completed. The error detection unit 23 may divide the frames included in the FPGA unit 20 into predetermined blocks and perform the CRC check on each block, instead of performing the CRC check on all the frames included in the FPGA unit 20 on a frame basis. For example, the error detection unit 23 divides the FPGA unit 20 into four blocks from a block constituting functional unit A to a block constituting functional unit D, and performs the CRC check on each block.

When the presence or absence of the soft error of the CRAM 21 is determined in the entire FPGA unit 20, the soft error cannot be identified even when the soft error occurs in an unused portion which does not constitute the functional unit. Therefore, in this embodiment, the functional unit constituting the FPGA unit 20 corresponding to the position in the FPGA unit 20 in which the soft error occurs (hereinafter also referred to as a position of the soft error) is specified. Specifically, an abnormality determination unit 15 of the processor unit 10 determines the functional unit corresponding to the position of the soft error detected by the error detection unit 23 on the basis of map information 16.

First, when the error detection unit 23 detects the soft error, the error detection unit 23 writes log information including content of the detected soft error to a register of the user circuit 22 via the error reading unit 24. The log information includes, for example, the position of the soft error (address information of the place of occurrence), and an error occurrence situation flag as the content of the detected soft error. Further, in the log information, sequentially, content of the soft error detected for the first time is held in log 0, and content of the soft error detected for the second time is held in log 1. Further, the error detection unit 23 writes a status including information such as the number of soft errors that have occurred or a confirmation situation of the processor unit 10 to the register of the user circuit 22.

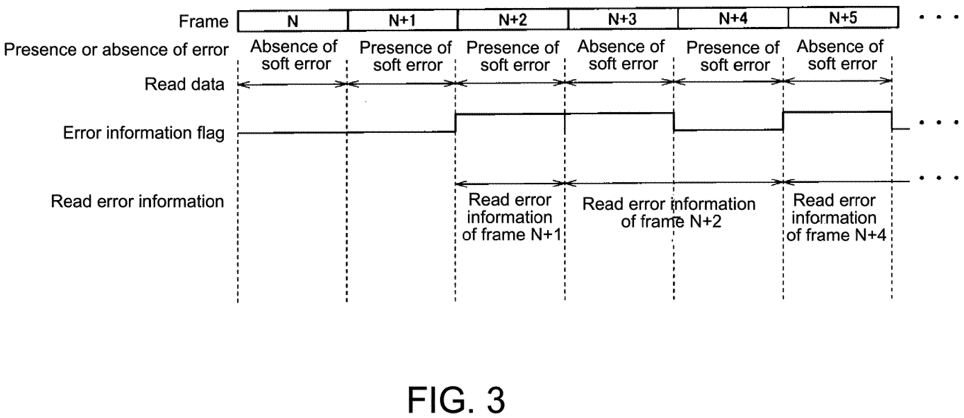

A read timing of error information in the error reading unit 24 will be described herein. FIG. 3 is a timing chart illustrating an example of the read timing of the error information in the error reading unit 24 in this embodiment. In the timing chart illustrated in FIG. 3, timings from a frame N to a frame N+5 of the CRAM 21 are illustrated. The error detection unit 23 detects a soft error in a frame N+1, a frame N+2, and a frame N+4 of the CRAM 21. Even when the error detection unit 23 detects the soft error in the frame N+1 of the CRAM 21, an error information flag does not enter an ON state in a data read period of the frame N+1. In the error detection unit 23, the error information flag for the soft error detected in the frame N+1 enters an ON state in the next frame N+2. Therefore, the error reading unit 24 reads the error information of the soft error detected in the frame N+1 from the error detection unit 23 in the data read period of the frame N+2.

Similarly, even when the error detection unit 23 detects the soft error in the frame N+2 of the CRAM 21, the error information flag does not enter an ON state in a data read period of the frame N+2. In the error detection unit 23, the error information flag for the soft error detected in the frame N+2 enters an ON state in the next frame N+3. Therefore, the error reading unit 24 reads the error information of the soft error detected in the frame N+2 from the error detection unit 23 in the data read period of the frame N+3. Since the soft error is not detected in the frame N+3 of the CRAM 21, the error information flag enters an OFF state in the data read period of the frame N+4. However, since the error reading unit 24 does not need to read the error information of the soft error detected in the frame N+3 in the data read period of the frame N+4, the error reading unit 24 continuously reads the error information of the soft error detected in the frame N+2.

Referring back to FIG. 2, when the error detection unit 23 detects the soft error, the error detection unit 23 transmits an interrupt notification to the processor unit 10. When the processor unit 10 receives the interrupt notification, a process in the abnormality determination unit 15 is started. The abnormality determination unit 15 reads the position of the soft error from the log information held in the user circuit 22 by referring to the log information via a communication IF (Interface) 25 of the FPGA unit 20. The abnormality determination unit 15 determines the functional unit to which the read position of the soft error corresponds on the basis of the map information 16. The read position of the soft error includes a position number. In the map information 16, information on the functional unit corresponding to this position number is stored. That is, the map information 16 includes position information (position number) in the FPGA unit 20 corresponding to the functional unit in the FPGA unit 20.

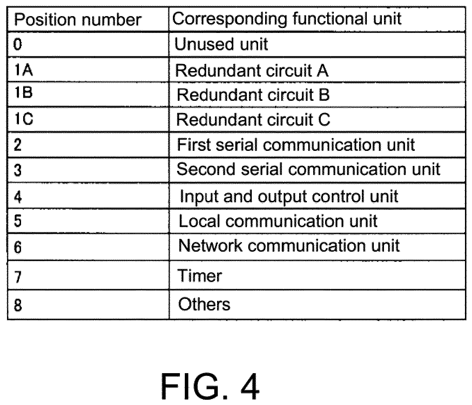

FIG. 4 is a diagram illustrating an example of the map information 16 in this embodiment. In the map information 16, information on position numbers 0 to 8 and names of functional units corresponding thereto is stored. For position number 0, the corresponding functional unit is an unused portion. For position number 1, the corresponding functional unit is a redundant circuit unit. More specifically, position number 1A corresponds to a redundant circuit A, position number 1B corresponds to a redundant circuit B, and position number 1C corresponds to a redundant circuit C. For position number 2, the corresponding functional unit is a first serial communication unit. For position number 3, a corresponding functional unit is a second serial communication unit. For position number 4, the corresponding functional unit is an input and output control unit. For position number 5, the corresponding functional unit is a local communication unit. For position number 6, the corresponding functional unit is a network communication unit. For position number 7, the corresponding functional unit is a functional unit of a timer. For position number 8, the corresponding functional unit is another functional unit.

When the abnormality determination unit 15 has determined the functional unit to which the read position of the soft error corresponds on the basis of the map information 16, the abnormality determination unit 15 writes that information as the status held in the user circuit 22 to update the status. For example, the abnormality determination unit 15 writes information regarding which of the unused portion, the redundant circuit unit, and the used circuit unit is the functional unit determined in the read log information, to the status to update the status. In the status, unanalyzed information is stored in the log information that has not yet been analyzed by the abnormality determination unit 15. Therefore, when the abnormality determination unit 15 reads the position of the soft error from the log information, the abnormality determination unit 15 can identify the log information that has not yet been analyzed by referring to the status.

The map information 16 is formed when configuration data for setting functional units included in the user circuit 22 is created, and is stored in a memory unit (for example, the RAM 12) of the processor unit 10.

In the related art, since the functional unit to which the read position of the soft error corresponds cannot be specified, the control device is mechanically stopped when the soft error is detected for the purpose of preventing a fraudulent operation of the FPGA. Therefore, there is a problem in that the control device is stopped even when a soft error not affecting a function (a soft error occurring in the unused portion) occurs, and unnecessary stop occurs. Further, the unnecessary stop can be prevented by separately diagnosing the presence or absence of the fraudulent operation using a diagnosis program or the like when a soft error occurs, but there are problems in that a detection rate of the presence or absence of the fraudulent operation of the diagnosis program or the like is low and a period for executing the diagnosis may be necessary.

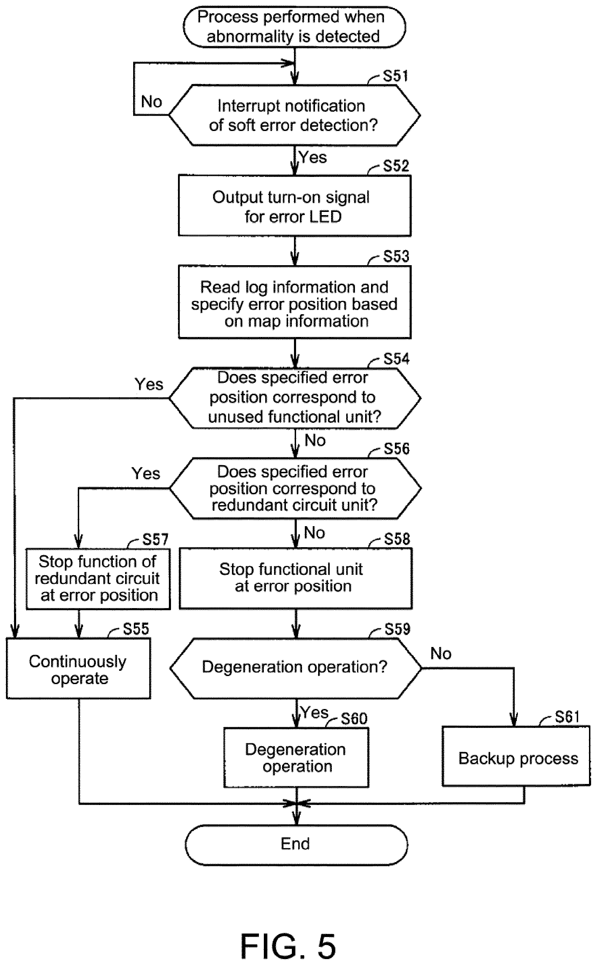

Therefore, as described above, the abnormality determination unit 15 can determine the functional unit to which the read position of the soft error corresponds on the basis of the map information 16, thereby preventing unnecessary stop. Specifically, the process performed when an abnormality is detected in this embodiment will be described below. FIG. 5 is a flowchart illustrating the process performed when an abnormality is detected in this embodiment.

First, the processor unit 10 determines whether or not the interrupt notification for soft error detection has been received from the error detection unit 23 (step S51). When the processor unit 10 determines that the interrupt notification is not received (step S51; NO), the processor unit 10 continues to wait for reception of the interrupt notification and executes a normal process. When the processor unit 10 determines that the interrupt notification has been received (step S51: YES), the processor unit 10 outputs a turn-on signal for turning on an error LED (not illustrated) (step S52). The error LED is a notification means that is provided in the control device, a controller connected to the control device, or the like, and is for notifying the user of the occurrence of the error. The notification means is not limited to the error LED, and may be a display device such as an LCD, a speaker for outputting error sound, or the like.

Then, the processor unit 10 (particularly, the abnormality determination unit 15) reads the log information from the user circuit 22 and specifies the error position on the basis of the map information 16 (step S53). Here, specifying the error position is specifying the functional unit configured in the FPGA unit 20 to which the position of the soft error detected by the error detection unit 23 corresponds. For example, when the position of the soft error is position number 4 (see FIG. 4), the abnormality determination unit 15 determines that the functional unit at the specified error position is the input and output control unit.

Next, the processor unit 10 (particularly, the abnormality determination unit 15) determines whether or not the specified error position corresponds to an unused functional unit (step S54). For example, when the position of the soft error is position number 0 (see FIG. 4), the abnormality determination unit 15 determines that the functional unit at the specified error position is an unused portion. When the processor unit 10 determines that the specified error position corresponds to an unused functional unit (step S54: YES), the processor unit 10 continuously operates the control device 100 (step S55). That is, even when the soft error occurs in the unused functional unit, the control device 100 can function normally, and therefore the control device 100 continuously performs the operation without being stopped, thereby preventing unnecessary stop even when the soft error occurs. The processor unit 10 continuously operates the control device 100 in step S55 and then ends the process performed when an abnormality is detected.

Then, when the processor unit 10 determines that the specified error position is not an unused functional unit (step S54: NO), the processor unit 10 (particularly, the abnormality determination unit 15) determines whether or not the specified error position corresponds to a redundant circuit functional unit (step S56). Here, the redundant circuit unit is a circuit unit that is redundant, and circuits having the same function are formed in a duplicated manner. For example, a duplicated circuit unit in which circuits having the same functions are duplicated and a redundant circuit unit in which circuits having the same function are triplicated and a majority vote is performed are included. In the example illustrated in FIG. 4, circuits having the same functions are triplicated as redundant circuit A, redundant circuit B, and redundant circuit C.

When the processor unit 10 determines that the specified error position corresponds to a redundant circuit functional unit (step S56: YES), the processor unit 10 stops the function of the redundant circuit at the error position (step S57). For example, when the position of the soft error is position number 1A (see FIG. 4), the abnormality determination unit 15 stops the function of the redundant circuit A at the specified error position. When the soft error has occurred in the redundant circuit unit, the processor unit 10 stops only the circuit in which the soft error has occurred in the redundant circuit unit. That is, when the redundant circuit unit is a redundant circuit unit in triplicate with redundant circuit A, redundant circuit B, and redundant circuit C, the processor unit 10 stops only a function of redundant circuit A, and executes processes in the remaining redundant circuits B and C. Thereafter, the processor unit 10 continuously operates the control device 100 with redundant circuit B and redundant circuit C (step S55). That is, even when the soft error occurs in some of the circuits in the redundant circuit unit, the control device 100 can function normally, and therefore the control device 100 continuously performs the operation without being stopped, thereby preventing unnecessary stop even when the soft error occurs. The processor unit 10 ends the process performed when an abnormality is detected after continuously operating the control device 100 in step S55.

Then, when the processor unit 10 determines that the specified error position does not correspond to the redundant circuit unit as a functional unit (step S56: NO), the processor unit 10 stops the functional unit at the error position (step S58). For example, when the position of the soft error is position number 2 (see FIG. 4), the abnormality determination unit 15 determines that the functional unit at the specified error position is the first serial communication unit. The processor unit 10 stops only the functional unit of the first serial communication unit in which the soft error has occurred.

The processor unit 10 determines whether or not the control device 100 can perform a degeneration operation in a state in which the processor unit 10 stops only the circuit in which the soft error has occurred in step S57 (step S59). Specifically, the processor unit 10 prepares degeneration operation information indicating whether the degeneration operation is "possible" or "not possible" when the soft error has occurred, as a table in advance, reads the degeneration operation information corresponding to the functional unit stopped in step S58 from the table, and performs the determination. The processor unit 10 can maintain the operation of the control device 100 even when there is no functional unit stopped in step S58, and registers a functional unit that does not affect processes of other functional units in the table as degeneration operation "possible." For example, when a process for the device connected to the second serial communication unit is not affected even if only the functional unit of the first serial communication unit is stopped, the function of the first serial communication unit is degenerated and the operation can be continued, When the processor unit 10 determines that the control device 100 can perform the degeneration operation (step S59: YES), the processor unit 10 causes the control device 100 to perform the degeneration operation in a state in which the processor unit 10 stops some of the functional units in step S57 (step S60). By causing the control device 100 to perform the degeneration operation even when some of the functional units cannot be used, unnecessary stop is prevented even when the soft error occurs. The processor unit 10 ends the process performed when an abnormality is detected after causing the control device 100 to perform the degeneration operation in step S60.

Next, when the processor unit 10 determines that the control device 100 cannot perform the degeneration operation (step S59: NO), the processor unit 10 starts a backup process to stop the control device 100 (step S61). For example, when the position of the soft error is position number 5 (see FIG. 4), the abnormality determination unit 15 determines that the functional unit at the specified error position is the local communication unit. When the soft error occurs in the local communication unit, the processor unit 10 concludes that the operation of the control device 100 cannot be maintained, and forcibly stops the FPGA unit 20. When the FPGA unit 20 is stopped, it may be needed to perform a process of storing, for example, data required to restart the FPGA unit 20 in the RAM 12, and therefore, the processor unit 10 starts the backup process in step S61. The processor unit 10 forcibly stops the FPGA unit 20 after completing the backup process in step S61.

When the processor unit 10 performs the backup process in step S61 and forcibly stops the FPGA unit 20, the processor unit 10 can perform reconfiguration on the FPGA unit 20 to reconfigure a functional unit capable of performing a desired circuit operation and perform restart. After the processor unit 10 performs the backup process in step S61 and forcibly stops the FPGA unit 20, the processor unit 10 ends the process performed when an abnormality is detected.

As described above, in the control device 100 according to this embodiment, the abnormality determination unit 15 determines the correspondence between the position of the soft error detected by the error detection unit 23 and the functional unit on the basis of the map information indicating the correspondence between the position (position number) in the FPGA unit 20 and the functional unit in the FPGA unit 20. Further, when the abnormality determination unit 15 determines that the position of the soft error corresponds to a portion (an unused portion) of the FPGA unit 20 unused by the functional unit, the processor unit 10 continues to operate the control device 100, and when the abnormality determination unit 15 determines that the position of the soft error corresponds to a portion (a used portion) of the FPGA unit 20 (for example, a redundant circuit unit or a used circuit unit) used by the functional unit, the processor unit 10 performs a predetermined process. Therefore, the control device 100 can prevent unnecessary stop while realizing high reliability even when the soft error occurs in the FPGA unit 20.

Further, the predetermined process may be a process of stopping the FPGA unit 20 or may be a process of switching to the degeneration operation in which only the functional unit at the position of the soft error is stopped. By causing the control device 100 to perform the degeneration operation, it is also possible to prevent unnecessary stop. The predetermined process may be a process of temporarily stopping the operation of the control device 100, a process of notifying that the software error has occurred, a process of performing an operation in which the occurrence of the soft error has been recorded, or the like.

Further, when the abnormality determination unit 15 determines that the position of the soft error corresponds to a redundant circuit (for example, a redundant circuit unit), the processor unit 10 stops only the redundant circuit at the position of the soft error and continuously operates the control device. Further, when the abnormality determination unit 15 determines that the position of the soft error corresponds to a non-redundant circuit (for example, a used circuit unit), and when the processor unit 10 determines that the degeneration operation can be performed, the processor unit 10 executes a process of switching to the degeneration operation in which only the functional unit at the position of the soft error is stopped. Therefore, the control device 100 can prevent unnecessary stop while realizing high reliability even when the soft error occurs in the redundant circuit of the FPGA unit 20.

Further, in the method of controlling the control device 100 according to this embodiment, a step (step S53) of determining correspondence between the position of the soft error detected by the error detection unit 23 and the functional unit is performed on the basis of the map information. Further, in the control method, a step (step S55) of continuing the operation of the control device 100 when the position of the soft error is determined to correspond to the portion of the FPGA unit unused by the functional unit is performed. Further, in the control method, a step (steps S58 and S60) of executing the predetermined process when the position of the soft error is determined to correspond to a portion of the FPGA unit (for example, the redundant circuit unit and the used circuit unit) used by the functional unit is performed. Therefore, the method of controlling the control device 100 can prevent unnecessary stop while realizing high reliability even when the soft error occurs in the FPGA unit 20.

(Modification example)
(1) The case in which the error detection unit 23 according to this embodiment performs the detection of the soft error using all the frames included in the FPGA unit 20 as one unit has been described, but the invention is not limited thereto. For example, the error detection unit 23 may divide the CRAM 21 into predetermined blocks and detect the soft error for each block. The error detection unit 23 can detect the soft error without waiting for detection results of all the frames by dividing the CRAM 21 into a plurality of blocks and detecting the soft error.
(2) The case in which the processor unit 10 according to this embodiment executes the predetermined process when the abnormality determination unit 15 determines that the position of the soft error corresponds to the portion of the FPGA unit 20 (for example, a redundant circuit unit and a used circuit unit) used by the functional unit has been described, but the invention is not limited thereto. For example, the processor unit 10 may execute the predetermined process in consideration of whether or not the position is a position of the soft error detected in the past on the basis of the log information of the user circuit 22. Therefore, when the soft error occurs at the same position, the control device 100 can be stopped and unnecessary stop can be prevented.
(3) The case in which the processor unit 10 according to this embodiment continuously operates the control device 100 in a state in which the processor unit 10 stops only the redundant circuit in which the soft error has occurred when the functional unit at the error position is the redundant circuit unit has been described, but the invention is not limited thereto. For example, when the functional unit at the error position is three or more redundant circuits, the processor unit 10 may cause the degeneration operation to be performed when the number of redundant circuits to be stopped due to the occurrence of the soft error is a majority.
(4) The case in which the processor unit 10 according to this embodiment executes the predetermined process when the soft error occurs in the used circuit unit has been described, but the invention is not limited thereto. For example, the function of the used circuit unit may be weighted and the processor unit 10 may change a process to be executed on the basis of the weighting when a soft error occurs in the used circuit unit. Specifically, the processor unit 10 forcibly stops the FPGA unit 20 when a soft error occurs in a used circuit unit having a function of a local communication unit, but causes the degeneration operation to be performed when a soft error occurs in a used circuit unit having a function of a serial communication unit.
(5) In the control device 100 according to this embodiment, the process performed when an abnormality occurs due to the soft error in the configurations illustrated in FIG. 1 and FIG. 2 has been described. However, this configuration is merely an example, and any configuration may be adopted as long as the same process performed when an abnormality occurs can be performed.

### [Explanation of Labels]

10 Processor unit; 11 ROM; 12 RAM; 15 Abnormality determination unit; 16 Map information; 20 FPGA unit; 21 CRAM; 22 User circuit; 23 Error detection unit; 24 Error reading unit; 25 Communication IF; 30 I/O unit; 100 Control device; 200 Input and output device; S51 to S61 steps.

## Claims

1. A control device (100), comprising at least a programmable circuit unit (20) and an arithmetic processing unit (10) connected to the programmable circuit unit (20), capable of executing a user program in the arithmetic processing unit (10),
wherein the programmable circuit unit (20) comprises:
a functional unit (22) configured in the programmable circuit unit (20) including an input and output unit (30) configured for inputting signals from external switches or sensors and outputting signals to external relays or actuators;
a storage unit (21) for storing configuration data of the functional unit (22); and
an error detection unit (23) configured for detecting a soft error of the storage unit (21);
wherein the arithmetic processing unit (10) comprises:
a memory unit (16) for storing map information including position information in the programmable circuit unit (20) corresponding to the functional unit (22) in the programmable circuit unit (20); and
an abnormality determination unit (15) configured for determining a correspondence between a position of the soft error detected by the error detection unit (23) and the functional unit (22) on the basis of the map information; and
wherein the arithmetic processing unit (10) is configured for:
continuing an operation of the control device (100) when the abnormality determination unit (15) determines that the position of the soft error corresponds to a portion of the programmable circuit unit unused by the functional unit (22); and
executing a predetermined process when the abnormality determination unit (15) determines that the position of the soft error corresponds to a portion of the programmable circuit unit used by the functional unit (22);
**characterized in that** the functional unit (22) comprises a first functional unit including a redundant circuit and a second functional unit including a non-redundant circuit, and
the arithmetic processing unit (10) is further configured for:
stopping only a circuit at the position of the soft error and continuously operating the control device (100) when the abnormality determination unit (15) determines that the position of the soft error corresponds to the first functional unit,
executing a process of switching to a degeneration operation in which only the functional unit (22) at the position of the soft error is stopped when the abnormality determination unit (15) determines that the position of the soft error corresponds to the second functional unit, and
performing the degeneration operation or starting a backup process based on whether or not the control device (100) can perform the degeneration operation.

2. The control device (100) according to claim 1, wherein the arithmetic processing unit (10) is configured for executing the predetermined process as a process of stopping the programmable circuit unit (20).

3. The control device (100) according to claim 1, wherein the arithmetic processing unit (10) is configured for executing the predetermined process as a process of switching to the degeneration operation in which only the functional unit (22) at the position of the soft error is stopped.

4. The control device (100) according to any of claims 1 to 3, wherein the error detection unit (23) is configured for dividing the storage unit (21) into a plurality of predetermined blocks and detecting a soft error for each of the blocks.

5. The control device (100) according to any of claims 1 to 4, wherein the abnormality determination unit (15) is configured for executing the predetermined process in consideration of whether or not the position is a position of the soft error detected in the past.

6. The control device (100) according to any of claims 1 to 5, wherein the error detection unit (23) is configured for performing error detection using a cyclic redundancy check (CRC) code.

7. The control device (100) according to any of claims 1 to 6, wherein the programmable circuit unit (20) is a field-programmable gate array (FPGA) in which configuration data is stored in a static random access memory (SRAM) of the storage unit (21).

8. A method of controlling a control device (100) that comprises at least a programmable circuit unit (20) and an arithmetic processing unit (10) connected to the programmable circuit unit (20) and is capable of executing a user program in the arithmetic processing unit (10),
wherein the programmable circuit unit (20) comprises a functional unit (22) configured in the programmable circuit unit (20) including an input and output unit (30) configured for inputting signals from external switches or sensors and outputting signals to external relays or actuators and a storage unit (21) that stores configuration data of the functional unit (22), and an error detection unit (23) that detects a soft error of the storage unit,
the functional unit (22) further comprises a first functional unit including a redundant circuit and a second functional unit including a non-redundant circuit
the arithmetic processing unit (10) includes a memory unit (16) that stores map information including position information in the programmable circuit unit (20) corresponding to the functional unit (22) in the programmable circuit unit (20), and
the controlling method comprises steps of:
determining a correspondence between a position of a soft error detected by the error detection unit (23) and the functional unit (22) on the basis of the map information (S54);
continuing an operation of the control device (S55) when a position of the soft error is determined to correspond to a portion of the programmable circuit unit unused by the functional unit (22);
executing a predetermined process when the position of the soft error is determined to correspond to a portion of the programmable circuit unit used by the functional unit (22);
stopping only a circuit at the position of the soft error and continuously operating the control device (100) when the position of the soft error is determined to correspond to the first functional unit,
executing a process of switching to a degeneration operation in which only the functional unit (22) at the position of the soft error is stopped when the position of the soft error is determined to correspond to the second functional unit, and
performing the degeneration operation or starting a backup process based on whether or not the control device (100) can perform the degeneration operation.

## Patentansprüche

1. Steuerungsvorrichtung (100), umfassend mindestens eine programmierbare Schaltungseinheit (20) und eine mit der programmierbaren Schaltungseinheit (20) verbundene arithmetische Verarbeitungseinheit (10), die in der Lage ist, ein Anwenderprogramm in der arithmetischen Verarbeitungseinheit (10) auszuführen,
wobei die programmierbare Schaltungseinheit (20) umfasst:
eine Funktionseinheit (22), die in der programmierbaren Schaltungseinheit (20) konfiguriert ist und eine Ein- und Ausgabeeinheit (30) beinhaltet, die konfiguriert ist, um Signale von externen Schaltern oder Sensoren einzugeben und Signale an externe Relais oder Stellglieder auszugeben;
eine Speichereinheit (21) zum Speichern von Konfigurationsdaten der Funktionseinheit (22); und
eine Fehlererfassungseinheit (23), die zum Erfassen eines weichen Fehlers der Speichereinheit (21) konfiguriert ist;
wobei die arithmetische Verarbeitungseinheit (10) umfasst:
eine Speichereinheit (16) zum Speichern von Zuordnungsinformationen einschließlich Positionsinformationen in der programmierbaren Schaltungseinheit (20), die der Funktionseinheit (22) in der programmierbaren Schaltungseinheit (20) entspricht; und
eine Anomaliebestimmungseinheit (15), die zum Bestimmen einer Übereinstimmung zwischen einer Position des von der Fehlererkennungseinheit (23) erfassten weichen Fehlers und der Funktionseinheit (22) auf der Grundlage der Zuordnungsinformationen konfiguriert ist; und
wobei die arithmetische Verarbeitungseinheit (10) konfiguriert ist zum:
Fortsetzen eines Betriebs der Steuerungsvorrichtung (100), wenn die Anomalie-Bestimmungseinheit (15) bestimmt, dass die Position des weichen Fehlers einem Abschnitt der programmierbaren Schaltungseinheit entspricht, der von der Funktionseinheit (22) nicht verwendet wird; und
Ausführen eines vorbestimmten Prozesses, wenn die Anomalie-Bestimmungseinheit (15) bestimmt, dass die Position des weichen Fehlers einem Abschnitt der programmierbaren Schaltungseinheit entspricht, der von der Funktionseinheit (22) verwendet wird;
**dadurch gekennzeichnet, dass** die Funktionseinheit (22) eine erste Funktionseinheit mit einer redundanten Schaltung und eine zweite Funktionseinheit mit einer nicht-redundanten Schaltung umfasst, und
die arithmetische Verarbeitungseinheit (10) ferner konfiguriert ist zum:
Anhalten nur einer Schaltung an der Position des weichen Fehlers und zum kontinuierlichen Betreiben der Steuerungsvorrichtung (100), wenn die Anomaliebestimmungseinheit (15) bestimmt, dass die Position des weichen Fehlers der ersten Funktionseinheit entspricht,
Ausführen eines Prozesses zum Umschalten auf eine Degenerationsoperation, bei dem nur die Funktionseinheit (22) an der Position des weichen Fehlers angehalten wird, wenn die Anomaliebestimmungseinheit (15) bestimmt, dass die Position des weichen Fehlers der zweiten Funktionseinheit entspricht, und
Durchführen der Degenerationsoperation oder Starten eines Backup-Prozesses, je nachdem, ob die Steuerungsvorrichtung (100) die Degenerationsoperation durchführen kann oder nicht.

2. Steuerungsvorrichtung (100) nach Anspruch 1, wobei die arithmetische Verarbeitungseinheit (10) zum Ausführen des vorbestimmten Prozesses als einen Prozess zum Stoppen bzw. Anhalten der programmierbaren Schaltungseinheit (20) konfiguriert ist.

3. Steuerungsvorrichtung (100) nach Anspruch 1, wobei die arithmetische Verarbeitungseinheit (10) konfiguriert ist, um den vorbestimmten Prozess als einen Prozess des Umschaltens auf die Degenerationsoperation auszuführen, bei der nur die Funktionseinheit (22) an der Position des weichen Fehlers angehalten wird.

4. Steuerungsvorrichtung (100) nach einem der Ansprüche 1 bis 3, wobei die Fehlererkennungseinheit (23) konfiguriert ist, um die Speichereinheit (21) in eine Vielzahl von vorbestimmten Blöcken aufzuteilen und einen weichen Fehler für jeden der Blöcke zu erfassen.

5. Steuerungsvorrichtung (100) nach einem der Ansprüche 1 bis 4, wobei die Anomaliebestimmungseinheit (15) zum Ausführen des vorbestimmten Prozesses konfiguriert ist, unter Berücksichtigung der Frage, ob die Position eine Position des weichen Fehlers ist oder nicht, der in der Vergangenheit erfasst worden ist.

6. Steuerungsvorrichtung (100) nach einem der Ansprüche 1 bis 5, wobei die Fehlererkennungseinheit (23) konfiguriert ist, um eine Fehlererkennung unter Verwendung eines zyklischen Redundanzprüfcodes (CRC-Code) durchzuführen.

7. Steuerungsvorrichtung (100) nach einem der Ansprüche 1 bis 6, wobei die programmierbare Schaltungseinheit (20) ein feldprogrammierbare Gate-Array (FPGA) ist, in dem Konfigurationsdaten in einem statischen Direktzugriffsspeicher (SRAM) der Speichereinheit (21) gespeichert sind.

8. Verfahren zum Steuern einer Steuerungsvorrichtung (100), die mindestens eine programmierbare Schaltungseinheit (20) und eine mit der programmierbaren Schaltungseinheit (20) verbundene arithmetische Verarbeitungseinheit (10) umfasst und ein Anwenderprogramm in der arithmetischen Verarbeitungseinheit (10) ausführen kann,
wobei die programmierbare Schaltungseinheit (20) eine Funktionseinheit (22) umfasst, die in der programmierbaren Schaltungseinheit (20) konfiguriert ist, die eine Ein- und Ausgabeeinheit (30) umfasst, die konfiguriert ist, um Signale von externen Schaltern oder Sensoren einzugeben und Signale an externe Relais oder Stellglieder auszugeben, und eine Speichereinheit (21), die Konfigurationsdaten der Funktionseinheit (22) speichert, sowie eine Fehlererkennungseinheit (23), die einen weichen Fehler der Speichereinheit erfasst,
wobei die Funktionseinheit (22) weiterhin eine erste Funktionseinheit mit einer redundanten Schaltung und eine zweite Funktionseinheit mit einer nicht-redundanten Schaltung umfasst.
Wobei die arithmetische Verarbeitungseinheit (10) eine Speichereinheit (16) beinhaltet, die Zuordnungsinformationen einschließlich von Positionsinformationen in der programmierbaren Schaltungseinheit (20) speichert, die der Funktionseinheit (22) in der programmierbaren Schaltungseinheit (20) entspricht, und
wobei das Steuerungsverfahren die folgenden Schritte umfasst:
Bestimmen einer Übereinstimmung zwischen einer Position eines weichen Fehlers, der von der Fehlererfassungseinheit (23) und der Funktionseinheit (22) erfasst wird, auf der Grundlage der Zuordnungsinformationen (S54);
Fortsetzen eines Betriebs der Steuerungsvorrichtung (S55), wenn bestimmt wird, dass eine Position des weichen Fehlers einem Abschnitt der programmierbaren Schaltungseinheit entspricht, der nicht von der Funktionseinheit (22) verwendet wird;
Ausführen eines vorbestimmten Prozesses, wenn bestimmt wird, dass die Position des weichen Fehlers einem Abschnitt der programmierbaren Schaltungseinheit entspricht, der von der Funktionseinheit (22) verwendet wird;
Anhalten nur einer Schaltung an der Position des weichen Fehlers und kontinuierliches Betreiben der Steuerungsvorrichtung (100), wenn bestimmt wird, dass die Position des weichen Fehlers der ersten Funktionseinheit entspricht,
Ausführen eines Prozesses zum Umschalten auf eine Degenerationsoperation, bei der nur die Funktionseinheit (22) an der Position des weichen Fehlers angehalten wird, wenn bestimmt wird, dass die Position des weichen Fehlers der zweiten Funktionseinheit entspricht, und
Durchführen der Degenerationsoperation oder Starten eines Backup-Prozesses, je nachdem, ob die Steuerungsvorrichtung (100) die Degenerationsoperation durchführen kann oder nicht.

## Revendications

1. Dispositif de commande (100), comprenant au moins une unité de circuit programmable (20) et une unité de traitement arithmétique (10) connectée à l'unité de circuit programmable (20), apte à exécuter un programme d'utilisateur dans l'unité de traitement arithmétique (10),
dans lequel l'unité de circuit programmable (20) comprend :
une unité fonctionnelle (22) configurée dans l'unité de circuit programmable (20) comprenant une unité d'entrée et de sortie (30) configurée pour entrer des signaux provenant de commutateurs ou capteurs externes et délivrer des signaux vers des relais ou actionneurs externes ;
une unité de stockage (21) pour stocker des données de configuration de l'unité fonctionnelle (22) ; et
une unité de détection d'erreur (23) configurée pour détecter une erreur intermittente de l'unité de stockage (21) ;
dans lequel l'unité de traitement arithmétique (10) comprend :
une unité de mémoire (16) configurée pour stocker des informations de carte comprenant des informations de position dans l'unité de circuit programmable (20) correspondant à l'unité fonctionnelle (22) dans l'unité de circuit programmable (20) ; et
une unité de détermination d'anormalité (15) configurée pour déterminer une correspondance entre une position de l'erreur intermittente détectée par l'unité de détection d'erreur (23) et l'unité fonctionnelle (22) sur la base des informations de carte ; et
dans lequel l'unité de traitement arithmétique (10) est configurée pour :
poursuivre un fonctionnement du dispositif de commande (100) lorsque l'unité de détermination d'anormalité (15) détermine que la position de l'erreur intermittente correspond à une partie de l'unité de circuit programmable non utilisée par l'unité fonctionnelle (22) ; et
exécuter un processus prédéterminé lorsque l'unité de détermination d'anormalité (15) détermine que la position de l'erreur intermittente correspond à une partie de l'unité de circuit programmable utilisée par l'unité fonctionnelle (22) ;
**caractérisé par le fait que** l'unité fonctionnelle (22) comprend une première unité fonctionnelle comprenant un circuit redondant et une seconde unité fonctionnelle comprenant un circuit non redondant, et
l'unité de traitement arithmétique (10) est en outre configurée pour :
arrêter uniquement un circuit au niveau de la position de l'erreur intermittente et faire fonctionner en continu le dispositif de commande (100) lorsque l'unité de détermination d'anormalité (15) détermine que la position de l'erreur intermittente correspond à la première unité fonctionnelle,
exécuter un processus de commutation vers un fonctionnement de dégénération dans lequel uniquement l'unité fonctionnelle (22) au niveau de la position de l'erreur intermittente est arrêtée lorsque l'unité de détermination d'anormalité (15) détermine que la position de l'erreur intermittente correspond à la seconde unité fonctionnelle, et
réaliser le fonctionnement de dégénération ou démarrer un processus de sauvegarde sur la base du point de savoir si le dispositif de commande (100) peut ou non réaliser le fonctionnement de dégénération.

2. Dispositif de commande (100) selon la revendication 1, dans lequel l'unité de traitement arithmétique (10) est configurée pour exécuter le processus prédéterminé en tant que processus d'arrêt de l'unité de circuit programmable (20).

3. Dispositif de commande (100) selon la revendication 1, dans lequel l'unité de traitement arithmétique (10) est configurée pour exécuter le processus prédéterminé en tant que processus de commutation vers le fonctionnement de dégénération dans lequel uniquement l'unité fonctionnelle (22) au niveau de la position de l'erreur intermittente est arrêtée.

4. Dispositif de commande (100) selon l'une quelconque des revendications 1 à 3, dans lequel l'unité de détection d'erreur (23) est configurée pour diviser l'unité de stockage (21) en une pluralité de blocs prédéterminés et détecter une erreur intermittente pour chacun des blocs.

5. Dispositif de commande (100) selon l'une quelconque des revendications 1 à 4, dans lequel l'unité de détermination d'anormalité (15) est configurée pour exécuter le processus prédéterminé en considération du point de savoir si la position est ou non une position de l'erreur intermittente détectée précédemment.

6. Dispositif de commande (100) selon l'une quelconque des revendications 1 à 5, dans lequel l'unité de détection d'erreur (23) est configurée pour réaliser une détection d'erreur à l'aide d'un code de contrôle de redondance cyclique, CRC.

7. Dispositif de commande (100) selon l'une quelconque des revendications 1 à 6, dans lequel l'unité de circuit programmable (20) est une matrice prédiffusée programmable par l'utilisateur, FPGA, dans laquelle des données de configuration sont stockées dans une mémoire vive statique, SRAM, de l'unité de stockage (21).

8. Procédé de commande d'un dispositif de commande (100) qui comprend au moins une unité de circuit programmable (20) et une unité de traitement arithmétique (10) reliée à l'unité de circuit programmable (20) et est apte à exécuter un programme d'utilisateur dans l'unité de traitement arithmétique (10),
dans lequel l'unité de circuit programmable (20) comprend une unité fonctionnelle (22) configurée dans l'unité de circuit programmable (20) comprenant une unité d'entrée et de sortie (30) configurée pour entrer des signaux provenant de commutateurs ou capteurs externes et délivrer des signaux vers des relais ou actionneurs externes et une unité de stockage (21) qui stocke des données de configuration de l'unité fonctionnelle (22), et une unité de détection d'erreur (23) qui détecte une erreur intermittente de l'unité de stockage,
l'unité fonctionnelle (22) comprend en outre une première unité fonctionnelle comprenant un circuit redondant et une seconde unité fonctionnelle comprenant un circuit non redondant,
l'unité de traitement arithmétique (10) comprend une unité de mémoire (16) qui stocke des informations de carte comprenant des informations de position dans l'unité de circuit programmable (20) correspondant à l'unité fonctionnelle (22) dans l'unité de circuit programmable (20), et
le procédé de commande comprend les étapes suivantes :
déterminer une correspondance entre une position d'une erreur intermittente détectée par l'unité de détection d'erreur (23) et l'unité fonctionnelle (22) sur la base des informations de carte (S54) ;
poursuivre un fonctionnement du dispositif de commande (S55) lorsqu'une position de l'erreur intermittente est déterminée comme correspondant à une partie de l'unité de circuit programmable non utilisée par l'unité fonctionnelle (22) ;
exécuter un processus prédéterminé lorsque la position de l'erreur intermittente est déterminée comme correspondant à une partie de l'unité de circuit programmable utilisée par l'unité fonctionnelle (22) ;
arrêter uniquement un circuit au niveau de la position de l'erreur intermittente et faire fonctionner en continu le dispositif de commande (100) lorsque la position de l'erreur intermittente est déterminée comme correspondant à la première unité fonctionnelle,
exécuter un processus de commutation vers un fonctionnement de dégénération dans lequel uniquement l'unité fonctionnelle (22) au niveau de la position de l'erreur intermittente est arrêtée lorsque la position de l'erreur intermittente est déterminée comme correspondant à la seconde unité fonctionnelle, et
réaliser le fonctionnement de dégénération ou démarrer un processus de sauvegarde sur la base du point de savoir si le dispositif de commande (100) peut ou non réaliser le fonctionnement de dégénération.
